# EUROPEAN PATENT APPLICATION

(11) **EP 0 753 719 A1**
(43) Date of publication of application: **15.01.1997**
(21) Application number: 96110480.9
(22) Date of filing: 28.06.1996
(51) Int. Cl.: G01D 11/16, G01R 5/16

(54) **A device for controlling a magneto-electric instrument with crossed coils, for motor-vehicles**

(30) Priority: 13.07.1995 IT TO950593
(71) Applicant: MAGNETI MARELLI S.p.A., 20145 Milano (IT)
(72) Inventor: Sabatini, Franco, 27100 Pavia (IT)
(74) Representative: Quinterno, Giuseppe

(57) **Abstract**

The device comprises a processing and control circuit (8) with a supply input (8a) which can be connected to the voltage supply (B) and a signal input (8b) for receiving a variable signal indicative of the value of a quantity to be displayed by the instrument (1) and two outputs (OUT1, OUT2) for supplying control signals to the coils (C1, C2) of the instrument (1). The device also comprises a detector (14) for detecting the open/closed condition of a switch (9) which controls the supply of current from the supply (B) to the electrical system of the motor vehicle and correspondingly supplying an enabling/disabling signal. The processing and control circuit (8) is associated with an inhibitor circuit (15) controlled by the detector (14) for enabling/preventing the application of the variable signal to the signal input (8b) of the processing and control circuit (8) when the detector (14) provides an enabling/disabling signal and a timer (13) controlled by the detector (14) keeps the processing and control circuit (8) operative when the detector (14) provides an enabling signal and renders the circuit (8) inoperative with a predetermined delay after the receipt of a disabling signal emitted by the detector (14).

## Description

The present invention relates to a device for controlling a magneto-electric instrument with crossed coils for use in motor-vehicles, of the type defined in the introductory portion of the appended Claim 1.

A magneto-electric instrument with crossed coils typically comprises a movable assembly comprising a permanent magnet rotatable with a pointer and two stationary coils in a crossed arrangement around the movable assembly. In order to control an instrument of this type by means of a variable input signal indicative of the value of a quantity to be displayed by the instrument, two signals proportional to the sine and to the cosine of the angle of displacement of the pointer, respectively, are generated and are applied to the coils of the instrument. These signals cause corresponding currents to circulate in the coils and thus create magnetic fields which, by interacting with the field of the permanent magnet, generate a torque which rotates the assembly to an equilibrium position in which the pointer displays the value of the quantity monitored relative to a predetermined scale.

If the signals applied to the coils of the instrument are interrupted, the torque which acts on the movable assembly and hence on the pointer is cancelled out. The assembly then remains subject to the influence of the earth's magnetic field the relative orientation of which is random. In practice, in the absence of particular countermeasures, in the case of an instrument mounted on a motor vehicle, when the engine is switched off, the rest position adopted by the pointer will generally be other than the position at the beginning of the scale and, in any case, is completely unpredictable because of the random orientation of the motor vehicle relative to the earth's magnetic field.

To prevent this problem, some instruments of the type indicated above have a spiral spring for generating a torque opposing the rotation of the movable assembly In use, the movement of the movable assembly and hence of the pointer, depends upon the resultant torque, that is, upon the difference between the operating torque caused by the signals applied to the coils and the opposing torque generated by the spiral spring. In the absence of signals applied to the coils, the movable assembly is subject solely to the torque exerted by the biasing spring which brings the pointer back to the position at the beginning of the scale of the instrument and keeps it there.

In instruments in which the end of the scale is situated less than 180° from the beginning of the scale, the biasing spring has advantageously been replaced by a small auxiliary permanent magnet arranged appropriately on one side of the instrument so that the interaction between this auxiliary magnet and the main magnet of the instrument returns the pointer to the beginning of the scale when signals cease to be applied to the coils. This solution, which is much simpler and less expensive than that which provides for a biasing spring, cannot, however, be applied to instruments in which the end of the scale is situated more than 180° from the beginning of the scale. In fact, in these instruments, if the signals applied to the coils were to cease whilst the pointer were more than 180° from the beginning of the scale, the pointer would be returned towards the beginning of the scale by the shortest route, that is, in the sense of a continuation of its rotation, which is not generally considered "aesthetically" acceptable and, in many instruments, is actually impossible because of obstacles or mechanical stops interposed on the return path of the pointer beyond the end of the scale.

The object of the present invention is to provide an improved device for controlling instruments with crossed coils which enables the auxiliary magnet to be used for keeping the pointer in the position at the beginning of the scale even when the end of the scale is more than 180° from the beginning of the scale.

This object is achieved, according to the invention, by a control device, the main characteristics of which are defined in the appended Claim 1.

Further characteristics and advantages of the invention will become clear from the following detailed description given with reference to the appended drawings, provided purely by way of non-limiting example, in which:
Figure 1 is a block diagram of a device for controlling a magneto-electric instrument with crossed coils according to the prior art, and
Figure 2 is a block diagram of a device for controlling a magneto-electric instrument according to the invention.

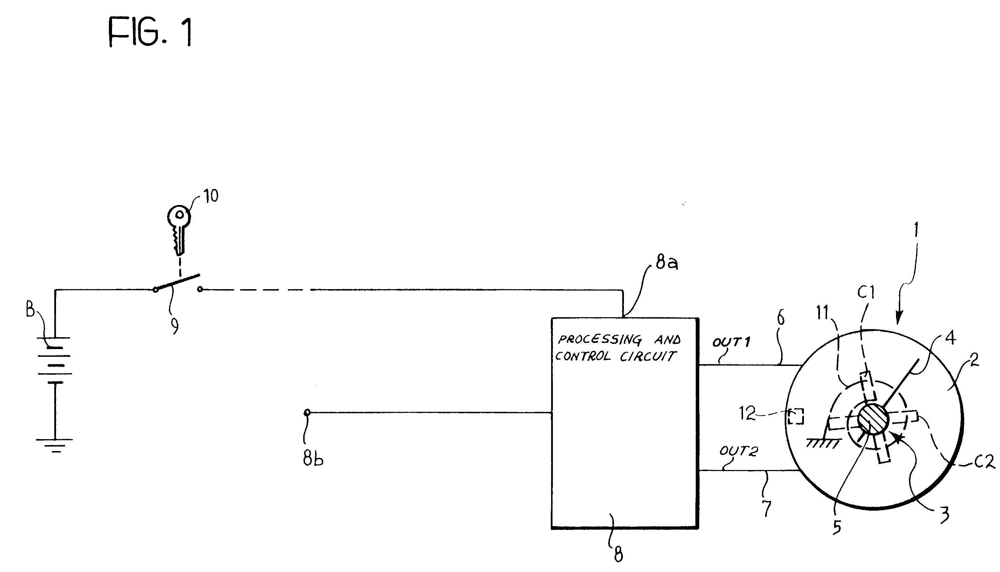

In Figure 1, a magneto-electric instrument of the type with crossed coils is indicated 1. The instrument comprises, in known manner, a casing 2 carrying a scale (not shown) in a fixed position. A movable device 3 supported for rotation in the casing, includes the pointer of the instrument 4 and a permanent magnet 5. The instrument also comprises two stationary coils C1 and C2, in a crossed arrangement.

The instrument 1 has two input terminals 6 and 7 connected to corresponding outputs of a processing and control circuit 8. This circuit has a supply input 8a which can be connected to the battery B of the motor vehicle by means of a manually-operable switch 9. This switch may be incorporated, for example, in the ignition and starter switch of the motor vehicle, operable by means of a key 10.

The processing and control circuit 8 has a further input 8b for receiving a variable signal indicative of the value of a quantity monitored which value is to be displayed by means of the instrument 1.

The processing and control circuit 8 is arranged, in known manner, to generate, on the basis of the signal applied to its input 8b, two output signals OUT1 and OUT2 which are applied to the coils C1 and C2, respectively. Naturally, the processing and control circuit 8 can operate provided that the switch 9 is closed.

The processing and control circuit is arranged, in particular, (in known manner) to process the input signal, particularly to integrate it and to provide a predetermined time constant for the movement of the pointer.

The pointer 4 moves, under the effect of the currents flowing in the coils C1 and C2 and the interaction of the magnetic field correspondingly generated with the magnetic field of the permanent magnet 3, to the position corresponding to the value of the quantity monitored and to be displayed.

If, whilst the switch 9 is closed, the signal at the input 8b of the circuit ceases, that is, is cancelled out, the circuit returns the pointer to the beginning of the scale with a predetermined time constant.

When the switch 9 is open, the processing and control circuit 8 is no longer supplied and it no longer applies the signals OUT1 and OUT2 to the coils C1 and C2.

In this situation, in order to return the pointer 4 to the beginning of the scale and to keep it there, according to the prior art, a biasing spring such as that shown schematically in broken outline in Figure 1 and indicated 11 therein is used, or, as stated above, a small auxiliary permanent magnet, indicated 12, is provided in the instrument.

As mentioned above, the solution with the auxiliary permanent magnet 12 is structurally and economically more advantageous but cannot be used in instruments in which the end of the scale is situated more than 180° from the beginning of the scale.

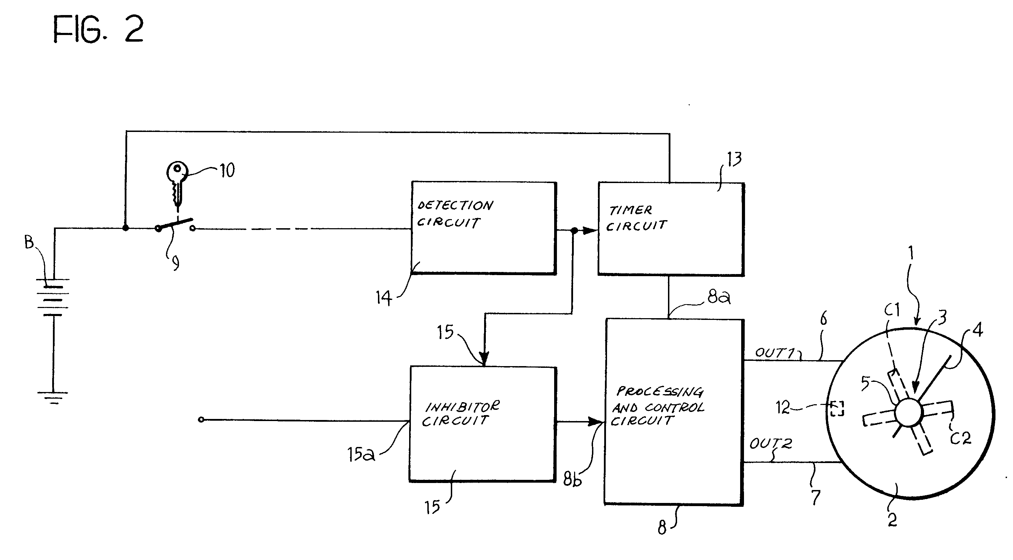

This limitation is overcome by a control device according to the invention such as that which will now be described with reference to Figure 2. In Figure 2, parts and elements already described above have again been given the same alphanumeric reference symbols.

In the device of Figure 2, the supply terminal 8a of the processing and control circuit 8 is connected to the battery B by means of a timer circuit 13. This timer circuit is connected permanently to the battery B, even when the switch 9 is open. A detector circuit 14 is connected to this switch for detecting the closed/open condition of the switch and providing corresponding enabling/disabling output signals.

The output of the detector circuit 14 is connected to a control input of the timer circuit 13. The latter is arranged to supply current directly to the input 8a of the processing and control circuit 8 each time it receives an enabling signal from the detection circuit 14 and to interrupt the supply of current to the processing and control circuit 8 with a predetermined delay after the receipt of a disabling signal coming from the detection circuit 14. This delay period is longer than the time required for the pointer 4 of the instrument 1 to be brought from the end of the scale to the beginning of the scale when the input signal of the processing and control circuit 8 ceases whilst the circuit is still supplied with current.

An inhibitor circuit, indicated 15, is disposed upstream of the input 8b of the processing and control circuit 8. This circuit has an input 15a to which the variable signal indicative of the value of the quantity monitored and to be displayed by the instrument 1 is applied in operation. The inhibitor circuit has a control input 15b connected to the detection circuit 14.

The inhibitor circuit 15 is arranged to transfer the signal applied to its input 15a to the input 8b of the processing and control circuit when the enabling signal provided by the detection circuit 14 is present at the input 15b and hence when the switch 9 is closed. The circuit 15 is also arranged to prevent the transfer of the signal applied to its input 15a towards the input 8b of the processing and control circuit 8 when a disabling signal is applied to the input 15b by the detection circuit 14, that is, when the switch 9 is open.

The device described above with reference to Figure 2 operates as follows.

When the switch 9 is closed, the detection circuit 14 provides an enabling signal to the timer circuit 13 and to the inhibitor circuit 15. The timer circuit 13 consequently supplies the processing and control circuit 8 directly, the input 8b of the processing and control circuit 8 receiving the signal indicative of the value of the quantity to be displayed by the instrument 1 via the inhibitor circuit 15. The signals OUT1 and OUT2 applied to the coils C1 and C2 of the instrument 1 cause the pointer 4 to move towards the position which corresponds to the value of the quantity monitored and to be displayed.

As soon as the switch 9 is opened, the detection circuit applies a disabling signal to the timer circuit 13 and to the inhibitor circuit 15. The inhibitor circuit 15 cancels out the signal at the input 8b of the processing and control circuit 8 to which current is supplied at the input 8a, however, by means of the timer circuit 13. During the delay period of the timer circuit 13, the circuit 8 returns the movable device and, in particular, the pointer 4 of the instrument to the beginning of the scale.

Since the delay period of the timer circuit 13 is greater than the maximum time expected for the pointer 4 to return to the beginning of the scale, when the delay period of the timer circuit 13 has elapsed, the pointer 4 is sure to have returned to the beginning of the scale, where it is kept firmly by the auxiliary magnet 12.

The various circuits of the device according to the invention described above can easily be formed by an expert in the art.

In connection with this device, it is pointed out that, although the foregoing description refers to an embodiment of the type with circuitry, that is, "hardware", the device according to the invention may also be formed by a programmable microprocessor unit. In an embodiment of this latter type, the circuits described with reference to Figure 2 are transformed from "hardware" components into "software" processes and the enabling/disabling signals emitted by the detection circuit in this case take the form of flags for controlling the activation of corresponding tasks.

Naturally, the principle of the invention remaining the same, the forms of embodiment and details of construction may be varied widely with respect to those described and illustrated purely by way of non-limiting example, without thereby departing from the scope of the present invention as defined in the appended Claims.

## Claims

1. A device for controlling a magneto-electric instrument (1) of the type with crossed coils (C1, C2) comprising an auxiliary permanent magnet (12) for keeping the pointer (4) in the position at the beginning of the scale in the absence of an input signal or supply voltage, particularly for a motor vehicle having a direct-current voltage supply (B), and in which the supply of current from the supply (B) to a portion of the electrical system of the vehicle is controlled by means of a switch (9) operable by the user, the device comprising processing and control circuitry (8) with a supply input (8a) for connection to the voltage supply (B) and a signal input (8b) for receiving a variable signal indicative of the value of a quantity to be displayed by the instrument (1) and two outputs (OUT1, OUT2) for providing control signals to the coils (C1, C2) of the instrument (1),
the device being characterized in that it further comprises
detector means (14) for detecting the open/closed condition of the switch (9) and correspondingly providing an enabling/disabling signal,
inhibitor means (15) associated with the processing and control means (8) and controlled by the detector means (14) for enabling/preventing the application of the variable signal to the signal input (8b) of the processing and control means (8) when the detector means (14) provide an enabling/disabling signal, and
timed connection means (13) which are also controlled by the detector means (14) and can keep the processing and control means (8) operative when the detector means (14) provide an enabling signal and render the processing and control means (8) inoperative with a predetermined delay after the receipt of a disabling signal emitted by the detector means (14), the delay period being longer than the time taken for the pointer (4) of the instrument (1) to return from the position at the end of the scale to the position at the beginning of the scale.
